# EUROPEAN PATENT APPLICATION

(11) **EP 4 025 023 A1**
(43) Date of publication of application: **06.07.2022**
(21) Application number: 20864562.2
(22) Date of filing: 03.08.2020
(51) Int. Cl.: H05K 7/20

(54) **HEAT DISSIPATION APPARATUS AND TERMINAL DEVICE**

(30) Priority: 17.09.2019 CN 201910875354
(71) Applicant: Huawei Technologies Co., Ltd., Longgang District Shenzhen, Guangdong 518129 (CN)
(72) Inventor: XIAO, Yongwang, Shenzhen, Guangdong 518129 (CN)
(74) Representative: Gill Jennings & Every LLP
(86) International application number: PCT/CN2020/106630
(87) International publication number: WO 2021/052043

(57) **Abstract**

This application provides a heat dissipation apparatus and a terminal device, and relates to the heat dissipation field. The heat dissipation apparatus has an adhesive region and a partial adhesive-free region. The adhesive region may be bonded to an internal structure, and there is no bonding relationship between the partial adhesive-free region and the internal structure. In addition, the partial adhesive-free region is disposed at least in a corner of the heat dissipation apparatus. In a process of detaching the heat dissipation apparatus, a part of a partial adhesive-free region in a corresponding corner of the heat dissipation apparatus may be directly lifted, and then the heat dissipation apparatus is torn off, to totally remove the heat dissipation apparatus. According to the heat dissipation apparatus in this application, detachment efficiency of the heat dissipation apparatus is high, and the heat dissipation apparatus may be effectively prevented from being damaged, so that the detached heat dissipation apparatus can still be used. This helps reduce production costs.

## Description

### CROSS-REFERENCE TO RELATED APPLICATIONS

This application claims priority to Chinese Patent Application No. 201910875354.3, filed with the China National Intellectual Property Administration on September 17, 2019 and entitled "HEAT DISSIPATION APPARATUS AND TERMINAL DEVICE", which is incorporated herein by reference in its entirety.

### TECHNICAL FIELD

This application relates to the field of heat dissipation device technologies, and in particular, to a heat dissipation apparatus and a terminal device.

### BACKGROUND

Currently, a graphite heat dissipation film or a graphene heat dissipation film (briefly referred to as a graphite film) is commonly used as a heat dissipation apparatus in a terminal device such as a mobile phone, a tablet computer, a notebook computer, and a personal digital assistant (personal digital assistant, PDA). Generally, the graphite film is a composite film obtained by combining a polymer film layer, a graphite layer or a graphene layer, and an adhesive layer. At least one surface of the graphite film partially or all has an adhesive layer, so that the graphite film is bonded and fastened to a part that is inside the terminal device and whose heat needs to be dissipated.

During mass production of the terminal device, a large amount of reworking occurs. Sometimes, the graphite film needs to be detached. The graphite film is easily damaged in a detachment process, and the damaged graphite film cannot be used again. In addition, the graphite film is further combined with a component such as an NFC antenna or a wireless charging coil and ferrite through bonding, to form an assembly. Because each component of the assembly cannot be detached, if the graphite film is damaged during detachment, an auxiliary component may be scrapped, and consequently resources are wasted.

### SUMMARY

Technical solutions of this application provide a heat dissipation apparatus and a terminal device, to improve detachment convenience of the heat dissipation apparatus.

According to a first aspect, the technical solutions of this application provide a graphite film, configured to dissipate heat for an internal structure. The graphite film includes an adhesive region and a partial adhesive-free region. The adhesive region may be bonded to the internal structure, and there is no bonding relationship between the partial adhesive-free region and the internal structure. In addition, in this application, the partial adhesive-free region is disposed in at least one corner of the graphite film. In this way, when the graphite film bonded to the internal structure by using the adhesive region is detached, a detachment tool such as tweezers or a hand may be first put into the adhesive-free region in the corner of the graphite film, to lift the part of graphite film. Then, the graphite film is torn off by using the hand or the detachment tool, so that an unbonded region between the graphite film and the internal structure is expanded, to totally remove the graphite film. According to the graphite film in this embodiment of this application, the partial adhesive-free region is disposed in the corner. This can facilitate detachment of the graphite film, and help improve detachment efficiency of the graphite film. In addition, in a process of detaching the graphite film, the graphite film may be effectively prevented from being damaged, so that the detached graphite film can still be used. This helps improve a reuse ratio of the graphite film and reduce production costs.

According to a second aspect, the technical solutions of this application further provide a terminal device, where the terminal device includes a display, a middle frame, a rear housing, a printed circuit board, and the graphite film according to the first aspect. The middle frame may be configured to bear the printed circuit board and the display. The display and the printed circuit board are located on two sides of the middle frame. The rear housing is located on a side of the printed circuit board that is away from the display. Heat emitting components are disposed on the printed circuit board, and the heat emitting components may be disposed on a side of the printed circuit board that is close to the middle frame, may be disposed on a side of the printed circuit board that is close to the rear housing, or may be disposed on two sides of the printed circuit board. The graphite film covers a region of the heat emitting component, to dissipate heat for the heat emitting component.

The partial adhesive-free region is disposed in the corner of the graphite film according to the first aspect. In this way, in a mass production process of the terminal device, when the graphite film is detached, a detachment tool such as tweezers or a hand may be first put into the partial adhesive-free region in the corner of the graphite film, to lift the part of graphite film. Then, the graphite film is torn off by using the hand or the detachment tool, so that an unbonded region between the graphite film and an internal structure of the terminal device is expanded, to totally remove the graphite film. In this embodiment of this application, the graphite film is easy to be detached, and detachment efficiency of the graphite film is high, so that reworking or maintenance efficiency of the terminal device is improved. In addition, in a process of detaching the graphite film, the graphite film may be prevented from being damaged, so that the detached graphite film can still be used. This helps improve a reuse ratio of the graphite film and reduce production costs.

### BRIEF DESCRIPTION OF DRAWINGS

FIG. 1 is a schematic diagram of a structure of a terminal device according to an embodiment of this application;
FIG. 2 is a schematic diagram of a structure of a graphite film according to an embodiment of a conventional technology;
FIG. 3 is a schematic diagram of a structure of a graphite film according to another embodiment of a conventional technology;
FIG. 4 is a schematic diagram of a structure of a heat dissipation apparatus according to an embodiment of this application;
FIG. 5 is a cross-sectional view of the heat dissipation apparatus in FIG. 4 at A-A;
FIG. 6 is a cross-sectional view of the heat dissipation apparatus in FIG. 4 at A-A;
FIG. 7 is a cross-sectional view of the heat dissipation apparatus in FIG. 4 at A-A;
FIG. 8 is a schematic diagram of a structure of a heat dissipation apparatus according to another embodiment of this application;
FIG. 9 is a schematic diagram of a structure of a heat dissipation apparatus according to another embodiment of this application;
FIG. 10 is a schematic diagram of a structure of a heat dissipation apparatus according to another embodiment of this application;
FIG. 11 is a schematic diagram of a structure of a heat dissipation apparatus according to another embodiment of this application; and
FIG. 12 is a schematic diagram of a structure of a heat dissipation apparatus according to another embodiment of this application.

Reference numerals:
1: display; 2: middle frame; 3: rear housing; 4: PCB; 5: heat dissipation apparatus; 6: heat emitting component; and 7: bracket;
8: battery compartment; 9: adhesive region; and 10A, 10B, and 10C: partial adhesive-free region;
11A, 11B, 11C, 11D, and 11E: polymer film layer; and 12A, 12B, and 12C: heat dissipation material layer; and
13A, 13B, and 13C: adhesive layer; and 14: graphite film.

### DESCRIPTION OF EMBODIMENTS

To facilitate understanding of a heat dissipation apparatus provided in the embodiments of this application, the following first describes an application scenario of the heat dissipation apparatus provided in the embodiments of this application. The heat dissipation apparatus may be disposed in a terminal device such as a mobile phone, a tablet computer, and a personal digital assistant (personal digital assistant, PDA), and may dissipate heat for a heat emitting component such as a chip in the terminal device. The heat emitting component includes but is not limited to a central processing unit (central processing unit, CPU), an artificial intelligence (artificial intelligence, AI) processor, a system on chip (system on chip, SoC), a power management unit, or another component whose heat needs to be dissipated. With reference to the accompanying drawings, the following describes in detail a specific disposition manner of the heat dissipation apparatus in the terminal device, to facilitate understanding of a process in which the heat dissipation apparatus transfers heat of the heat emitting component.

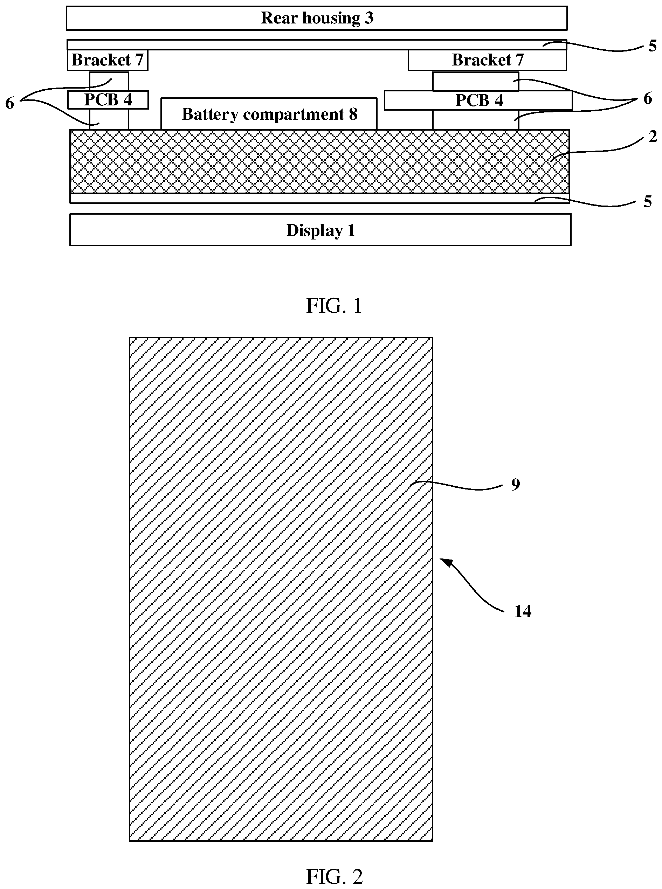

Referring to FIG. 1, in an embodiment of this application, a terminal device may include a display 1, a middle frame 2, a rear housing 3, a printed circuit board (printed circuit board, PCB 4), and a heat dissipation apparatus 5. The middle frame 2 may be configured to bear the PCB 4 and the display 1. The display 1 and the PCB 4 are located on two sides of the middle frame 2. The rear housing 3 is located on a side of the PCB 4 that is away from the display 1. Heat emitting components 6 (for ease of description, an example in which the heat emitting component 6 is a CPU is used for description below) are disposed on the PCB 4, and may be located on two sides of the PCB 4.

In addition, the terminal device may further include a bracket 7 fastened to the middle frame 2. The bracket 7 may extend to a side of the PCB 4 that is close to the rear housing 3, and may be configured to press the PCB 4 against the middle frame, or press and fasten a component on the PCB 4, to effectively improve structure stability of the PCB 4. The heat dissipation apparatus 5 may be disposed between the bracket 7 and the rear housing 3, and is fastened on a side of the bracket 7 that is close to the rear housing. In addition, when a shielding case covers the heat emitting component 6 on the PCB 4, the heat dissipation apparatus 5 may be bonded to the shielding case, or bonded to a side of the bracket 7 that is close to the shielding case. In addition, the heat dissipation apparatus 5 may be directly bonded to the rear housing 3. When the heat dissipation apparatus 5 dissipates heat for the heat emitting component 6 such as a CPU, first, heat generated by the heat emitting component 6 may be transferred to the heat dissipation apparatus 5. Then, the heat is dissipated by the heat dissipation apparatus 5. Finally, the heat is transferred to the rear housing 3 through convection and radiation by the heat dissipation apparatus 5, and is dissipated to the outside of the terminal device by using the rear housing 3.

The heat dissipation apparatus 5 may be close to the rear housing 3. In addition, the heat dissipation apparatus 5 may be disposed between the display 1 and the middle frame 2, and the heat dissipation apparatus 5 may be fastened to the middle frame 2. It may be learned from FIG. 1 that some heat emitting components 6 on the PCB 4 are close to the middle frame 2, and a battery compartment 8 configured to accommodate a battery is also disposed in the middle frame 2. In this way, heat generated by the foregoing heat emitting components 6 may be dissipated after the heat is transferred to the middle frame 2 and the battery compartment 8, and is transferred to the heat dissipation apparatus 5 by using the middle frame 2. The heat dissipation apparatus 5 dissipates the heat, transfers the heat to the display 1 through convection and radiation, and finally dissipates the heat to the outside of the terminal device by using the display 1. Therefore, heat is dissipated for the terminal device by using the heat dissipation apparatus 5. It may be understood that, when the heat dissipation apparatus 5 is disposed between the PCB 4 and the rear housing 3, the heat dissipation apparatus 5 may also be disposed between the frame 2 and the display 1, to improve heat dissipation efficiency of the terminal device. In addition, a disposition position of the heat dissipation apparatus 5 is not limited to the foregoing position in the terminal device, provided that heat can be dissipated for the heat emitting component 6 of the terminal device.

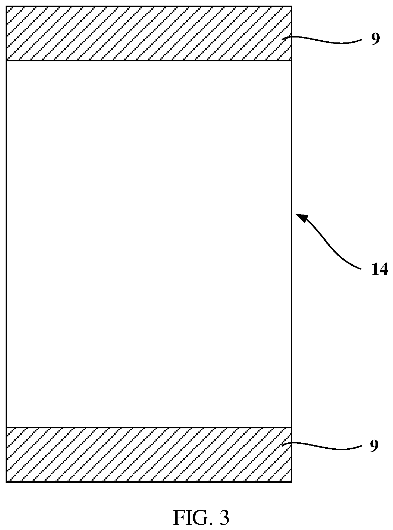

Currently, a graphite film 14 is a heat dissipation apparatus commonly used in the terminal device. Generally, the graphite film 14 is a composite film obtained by combining a polymer film layer, a graphite layer or a graphene layer, and an adhesive layer. When the graphite film 14 is specifically disposed, referring to FIG. 2, the graphite film 14 may have an adhesive region 9 on an entire surface, or referring to FIG. 3, the graphite film 14 may have a partial adhesive region 9. The adhesive layer is disposed in the adhesive region 9. It may be learned from FIG. 2 and FIG. 3 that corners of the graphite film 14 are filled with adhesive, to prevent the graphite film 14 from being lifted in a process of removing a protective film on a surface of the graphite film 14 when the graphite film 14 is bonded to the terminal device, so as to improve bonding reliability of the graphite film 14. In this way, when the graphite film 14 bonded inside the terminal device is detached, a corner of the graphite film 14 needs to be first lifted by using tips of tweezers. Then, after an area of the lifted graphite film 14 is expanded, the graphite film 14 may be torn off by using a hand. However, because the tweezers are excessively sharp, in a process of detaching the graphite film 14, the graphite film 14 is easily damaged. In addition, because the corners of the graphite film 14 are filled with the adhesive, it is difficult to detach the graphite film 14 and operation efficiency is low. In addition, materials of the torn graphite film 14 and the reworked graphite film 14 cannot be reused. Moreover, when the graphite film 14 is torn, a component (such as an NFC coil or a wireless charging coil and ferrite) assembled on the graphite film 14 may also be scrapped. Consequently, resources are wasted, and production costs are high.

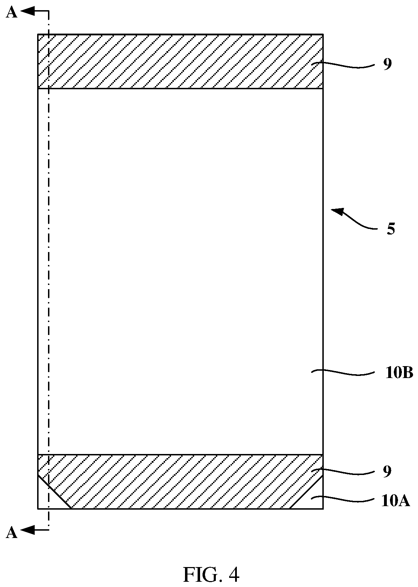

To resolve the foregoing problem, referring to FIG. 4, an embodiment of this application provides a heat dissipation apparatus 5. The heat dissipation apparatus 5 has an adhesive region 9 and a partial adhesive-free region 10A. The adhesive region 9 may be bonded to an internal structure, and there is no bonding relationship between the partial adhesive-free region 10A and the internal structure. In addition, the partial adhesive-free region 10A is disposed in at least one corner of the heat dissipation apparatus 5. The corner of the heat dissipation apparatus 5 is a convex part of a contour of the heat dissipation apparatus 5. During use, the heat dissipation apparatus 5 may be bonded to the internal structure by using the adhesive region 9. When the heat dissipation apparatus 5 needs to be detached, only the partial adhesive-free region 10A in the corner of the heat dissipation apparatus 5 needs to be lifted by using a hand, and then the heat dissipation apparatus 5 is slowly torn off, so that an unbonded region between the heat dissipation apparatus 5 and the internal structure is expanded, to totally remove the heat dissipation apparatus 5. According to the heat dissipation apparatus 5 in this embodiment of this application, the partial adhesive-free region 10A is disposed in the corner. This can facilitate detachment of the heat dissipation apparatus 5, and help improve detachment efficiency of the heat dissipation apparatus 5. In addition, in a process of detaching the heat dissipation apparatus 5, the heat dissipation apparatus 5 may be effectively prevented from being damaged, so that the detached heat dissipation apparatus 5 can still be reused. In addition, another component (such as an NFC coil and a wireless charging coil and ferrite) disposed on the heat dissipation apparatus 5 can be effectively prevented from being damaged, to help improve reuse ratios of the heat dissipation apparatus 5 and each component disposed on the heat dissipation apparatus 5, and reduce production costs.

When the adhesive region 9 is specifically disposed, referring to FIG. 4, the adhesive region 9 may be disposed at two opposite ends of the heat dissipation apparatus 5, and extends to an edge of the heat dissipation apparatus 5, so that bonding between the heat dissipation apparatus 5 and the internal structure is reliable. In addition, an intermediate region of the heat dissipation apparatus 5 may be further set as a partial adhesive-free region 10B. In this way, when the heat dissipation apparatus 5 is bonded to the internal structure, a component that is easily damaged can be avoided, to prevent another component from being damaged when the heat dissipation apparatus 5 is detached.

In addition, in this embodiment of this application, the partial adhesive-free region 10A in the corner of the heat dissipation apparatus 5 may fall within a rectangular region whose area is 15 mm×15 mm. Therefore, an area of the partial adhesive-free region 10A does not affect fastening of the heat dissipation apparatus 5 by the adhesive region 9, and a corner of the heat dissipation apparatus 5 is easily lifted, to facilitate detachment of the heat dissipation apparatus 5.

In some embodiments, a protective film (not shown in the figure) is further disposed on a surface of the heat dissipation apparatus 5. When the heat dissipation apparatus 5 is bonded to the internal structure, the protective film on the surface of the heat dissipation apparatus 5 needs to be torn off. Therefore, when the area of the partial adhesive-free region 10A in the corner of the heat dissipation apparatus 5 is set, the area further needs to ensure that bonding reliability between the heat dissipation apparatus 5 and a bonding part in a process of tearing off the protective film.

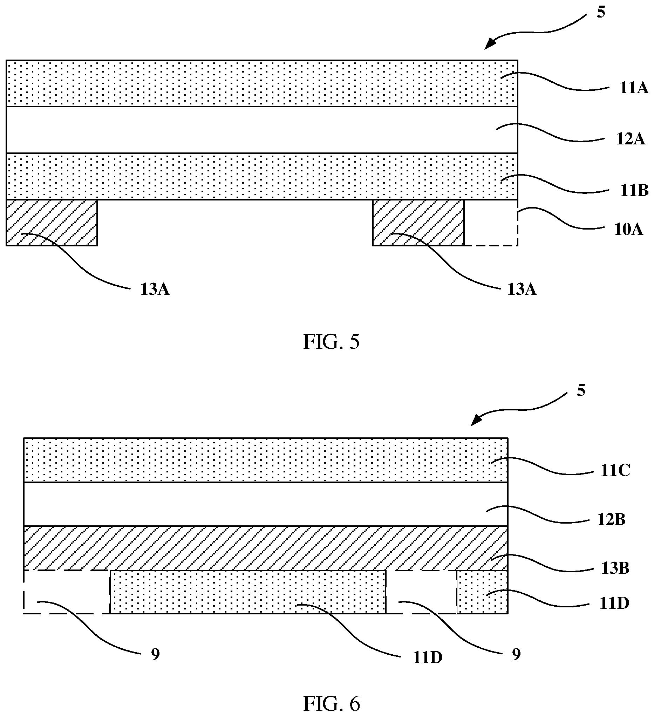

To help understand a structure of the heat dissipation apparatus 5 in this embodiment of this application more clearly, FIG. 5 is a cross-sectional view of the heat dissipation apparatus 5 in FIG. 4 at A-A. It may be learned from FIG. 5 that the heat dissipation apparatus 5 in this embodiment of this application is disposed in a stack structure, and includes a polymer film layer 11A, a heat dissipation material layer 12A, a polymer film layer 11B, and an adhesive layer 13A that are stacked. The polymer film layer 11A may alternatively be a metal foil layer (for example, copper foil or aluminum foil). The adhesive layer 13A is disposed in the adhesive region of the heat dissipation apparatus 5. In addition, the heat dissipation material layer 12A may be but is not limited to a graphite layer or a graphene layer. When the heat dissipation material layer 12A is a graphite layer, the heat dissipation apparatus 5 is a graphite heat dissipation film. When the heat dissipation material layer 12A is a graphene layer, the heat dissipation apparatus 5 is a graphene heat dissipation film. Both the graphite heat dissipation film and the graphene heat dissipation film may be briefly referred to as a graphite film. The polymer film layer 11A and the polymer film layer 11B are respectively disposed on two sides of the heat dissipation material layer 12A, so that the three layers are combined to form a film layer structure. In this way, this helps improve structure strength of the heat dissipation apparatus 5, so that the heat dissipation apparatus 5 is not easily damaged in a detachment process.

In addition, it may be learned from FIG. 5 that the heat dissipation apparatus 5 may be bonded and fastened to the internal structure by using the adhesive layer 13A. The partial adhesive-free region 10A is disposed in the corner of the heat dissipation apparatus 5, and there is no bonding relationship between the partial adhesive-free region 10A and the internal structure. In this way, the hand may be directly put into the partial adhesive-free region 10A, the film layer structure obtained by combining the polymer film layer 11A, the heat dissipation material layer 12A, and the polymer film layer 11B is clamped, and then the foregoing film layer structure is slowly torn off, so that there is no bonding relationship between the adhesive layer 13A and the internal structure, and the entire heat dissipation apparatus 5 is removed. In this way, this helps reduce a probability that the heat dissipation apparatus 5 is damaged.

In some embodiments, referring to FIG. 6, the heat dissipation apparatus may alternatively include a polymer film layer 11C, a heat dissipation material layer 12B, an adhesive layer 13B, and a polymer film layer 11D that are stacked. The polymer film layer 11C may alternatively be a metal foil layer (for example, copper foil or aluminum foil). The adhesive layer 13B is disposed on the entire surface of the heat dissipation apparatus 5. The polymer film layer 11D corresponds to the partial adhesive-free region of the heat dissipation apparatus 5. The polymer film layer 11D is disposed at a position that is at the adhesive layer 13B and that corresponds to the partial adhesive-free region, so that a part bonded to the polymer film layer 11D has no bondability. In addition, the heat dissipation material layer 12B may be but is not limited to a graphite layer or a graphene layer. The polymer film layer 11C and the adhesive layer 13B on the entire surface are respectively disposed on two sides of the heat dissipation material layer 12B. This helps improve structure strength of the heat dissipation apparatus 5, so that the heat dissipation apparatus 5 is not easily damaged in a detachment process.

In addition, it may be learned from FIG. 6 that the heat dissipation apparatus 5 may be bonded and fastened to the internal structure by using the adhesive layer located in the adhesive region 9. The partial adhesive-free region is disposed in the corner of the heat dissipation apparatus 5, and there is no bonding relationship between the adhesive-free region and the internal structure. In this way, a corner of a corresponding partial adhesive-free region of the heat dissipation apparatus 5 may be first lifted, and then a film layer structure in the corner may be clamped and slowly torn off, to totally remove the heat dissipation apparatus 5. According to the heat dissipation apparatus 5 in the technical solutions, detachment convenience of the heat dissipation apparatus 5 can be improved, and this helps reduce a probability that the heat dissipation apparatus 5 is damaged.

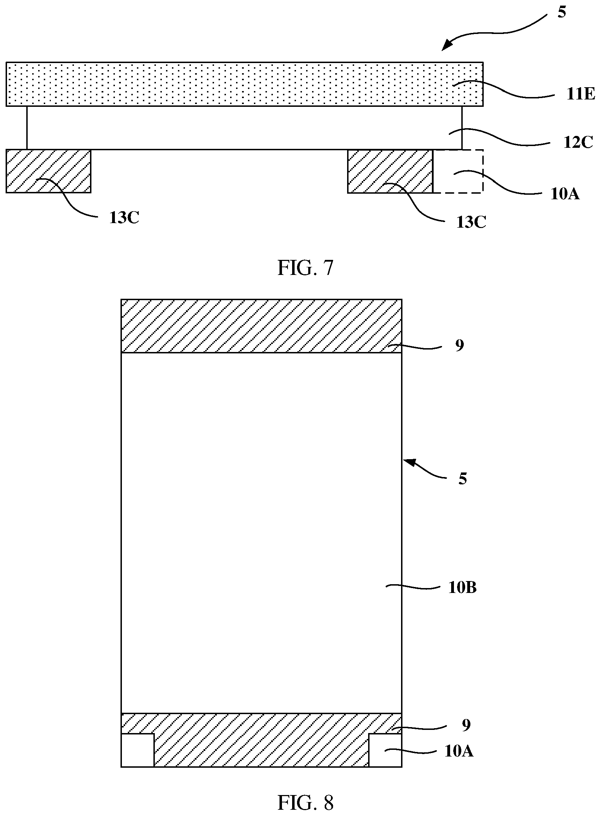

In some other embodiments, referring to FIG. 7, the heat dissipation apparatus 5 may alternatively include a polymer film layer 11E, a heat dissipation material layer 12C, and an adhesive layer 13C that are stacked. The polymer film layer 11E may alternatively be a metal foil layer (for example, copper foil or aluminum foil). The adhesive layer 13C is disposed in the adhesive region of the heat dissipation apparatus 5. In addition, the heat dissipation material layer 12C may be but is not limited to a graphite layer or a graphene layer. The heat dissipation apparatus 5 in this embodiment has a small quantity of film layer structures. When the heat dissipation apparatus 5 is applied to the terminal device, this helps implement a thin design of the terminal device.

In addition, it may be learned from FIG. 7 that the heat dissipation apparatus 5 may be bonded and fastened to the internal structure by using the adhesive layer 13C. The partial adhesive-free region 10A is disposed in the corner of the heat dissipation apparatus 5, and there is no bonding relationship between the partial adhesive-free region 10A and the internal structure. In this way, the partial adhesive-free region 10A may be directly lifted by using the hand, a film structure obtained by combining the polymer film layer 11E and the heat dissipation material layer 12C is clamped, and then the foregoing film layer structure is slowly torn off, so that there is no bonding relationship between the adhesive layer 13C and the internal structure, and the entire heat dissipation apparatus 5 is removed. In this way, this may facilitate detachment of the heat dissipation apparatus 5, and may effectively prevent the heat dissipation apparatus 5 from being damaged.

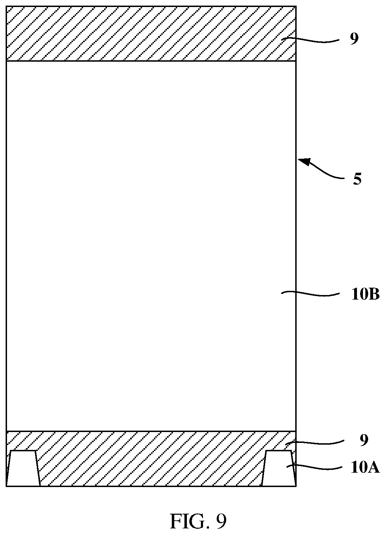

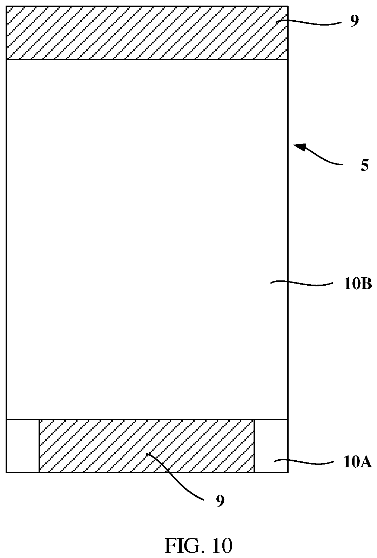

In each embodiment of this application, when the adhesive-free region is specifically disposed, a shape of the adhesive-free region may be but is not limited to a triangle (shown in FIG. 4), a rectangle shown in FIG. 8, or a trapezoid shown in FIG. 9. In addition, when the adhesive region is disposed only at two opposite ends of the heat dissipation apparatus 5, the intermediate region of the heat dissipation apparatus 5 is the partial adhesive-free region 10B. In this case, referring to FIG. 10, the partial adhesive-free region 10A disposed in the corner of the heat dissipation apparatus 5 is connected to the partial adhesive-free region 10B in the intermediate region. In this way, this helps rule out waste during production by using the partial adhesive-free region 10A and the partial adhesive-free region 10B that are connected to each other. In the design solutions of this application, a processing process is simple, and material costs are not increased.

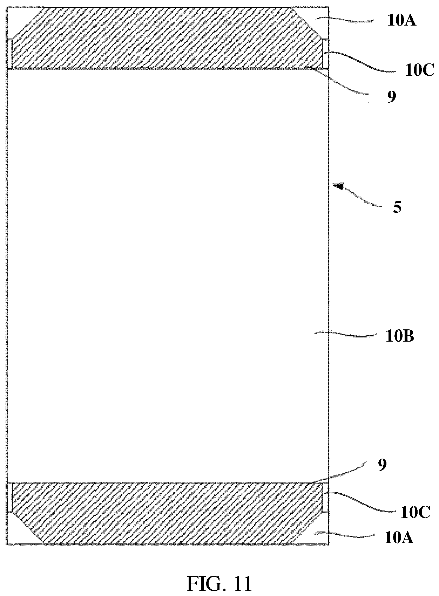

In addition, the partial adhesive-free region 10A may be disposed only in one corner of the heat dissipation apparatus 5. Alternatively, as shown in FIG. 8 to FIG. 10, the partial adhesive-free region 10A is disposed in two corners on a same side of the heat dissipation apparatus 5. Alternatively, as shown in FIG. 11, one partial adhesive-free region 10A is disposed in each corner of the heat dissipation apparatus 5. The partial adhesive-free region 10A may be but is not limited to a triangle, and the partial adhesive-free region 10A may be connected to the partial adhesive-free region 10B by using a strip partial adhesive-free region 10C. It should be noted that, regardless of how the partial adhesive-free region 10A is disposed, the partial adhesive-free region 10A needs to impose no impact on bonding reliability of the heat dissipation apparatus 5 while facilitating detachment of the heat dissipation apparatus 5.

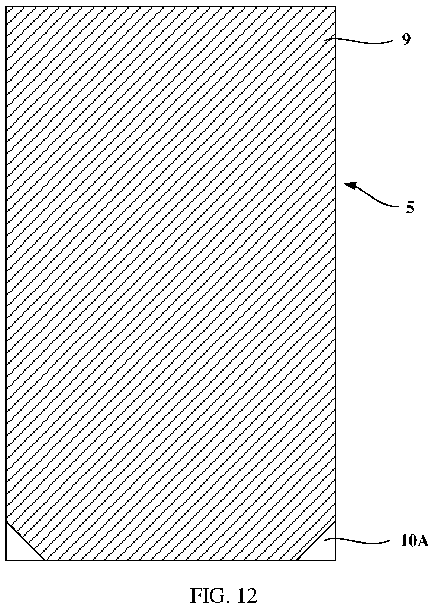

In some embodiments of this application, structure stability of the internal structure is strong. In this way, an area proportion of the adhesive region of the heat dissipation apparatus 5 may be increased, to implement bonding reliability between the heat dissipation apparatus 5 and the internal structure. For example, referring to FIG. 12, the partial adhesive-free region 10A may be disposed only in at least one corner of the heat dissipation apparatus 5, and all other parts are set as the adhesive region 9.

### Embodiments

1. A heat dissipation apparatus, configured to dissipate heat for an internal structure, where the heat dissipation apparatus includes an adhesive region and an adhesive-free region, the adhesive region is bonded to the internal structure, and the adhesive-free region is disposed at least in a corner of the heat dissipation apparatus.
2. The heat dissipation apparatus according to Embodiment 1, where the adhesive region is disposed at two opposite ends of the heat dissipation apparatus.
3. The heat dissipation apparatus according to Embodiment 1 or 2, where the adhesive region extends to an edge of the heat dissipation apparatus.
4. The heat dissipation apparatus according to any one of Embodiments 1 to 3, where the adhesive-free region is further disposed in an intermediate region of the heat dissipation apparatus.
5. The heat dissipation apparatus according to Embodiment 4, where the adhesive-free region disposed in the corner of the heat dissipation apparatus is connected to the adhesive-free region disposed in the intermediate region of the heat dissipation apparatus.
6. The heat dissipation apparatus according to any one of Embodiments 1 to 5, where the adhesive-free region disposed in the corner of the heat dissipation apparatus falls within a rectangular region whose area is 10 mm×10 mm.
7. The heat dissipation apparatus according to any one of Embodiments 1 to 6, where the heat dissipation apparatus further includes a first polymer film layer, a heat dissipation material layer, a second polymer film layer, and an adhesive layer that are sequentially stacked, and the adhesive layer is disposed in the adhesive region of the heat dissipation apparatus.
8. The heat dissipation apparatus according to any one of Embodiments 1 to 6, where the heat dissipation apparatus further includes a third polymer film layer, a heat dissipation material layer, an adhesive layer, and a fourth polymer film layer that are sequentially stacked, the adhesive layer is disposed on an entire surface of the heat dissipation apparatus, and the fourth polymer film layer corresponds to the adhesive-free region of the heat dissipation apparatus.
9. The heat dissipation apparatus according to any one of Embodiments 1 to 6, where the heat dissipation apparatus further includes a fifth polymer film layer, a heat dissipation material layer, and an adhesive layer that are sequentially stacked, and the adhesive layer is disposed in the adhesive region of the heat dissipation apparatus.
10. The heat dissipation apparatus according to any one of Embodiments 7 to 9, where the heat dissipation material layer is a graphite layer or a graphene layer.
11. The heat dissipation apparatus according to any one of Embodiments 1 to 9, where a shape of the adhesive-free region disposed in the corner of the heat dissipation apparatus is a triangle, a rectangle, or a trapezoid.
12. The heat dissipation apparatus according to any one of Embodiments 1 to 11, where the adhesive-free region is disposed in one corner of the heat dissipation apparatus, or the adhesive-free region is disposed in least two corners of the heat dissipation apparatus.
13. A terminal device, including a display, a middle frame, a rear housing, a printed circuit board, and the heat dissipation apparatus according to any one of Embodiments 1 to 12, where
   the middle frame is configured to bear the printed circuit board and the display, the display and the printed circuit board are located on two sides of the middle frame, and the rear housing is located on a side of the printed circuit board that is away from the display; and
   heat emitting components are disposed on the printed circuit board, and the heat dissipation apparatus covers a region of the heat emitting component.
14. The terminal device according to Embodiment 13, where the terminal device further includes a bracket fastened to the middle frame, and the bracket is configured to press the printed circuit board against the middle frame.
15. The terminal device according to Embodiment 14, where the heat dissipation apparatus is disposed on a side of the printed circuit board that is close to the rear housing.
16. The terminal device according to Embodiment 15, where the heat dissipation apparatus is bonded to a side of the bracket that is close to the rear housing, the heat dissipation apparatus is bonded to a side of the bracket that is close to the middle frame, or the heat dissipation apparatus is bonded to the rear housing.
17. The terminal device according to Embodiment 15, where a shielding case covers the heat emitting component, and the heat dissipation apparatus is bonded to the shielding case.
18. The terminal device according to any one of Embodiments 13 to 17, where the heat dissipation apparatus is further disposed between the middle frame and the display, and the heat dissipation apparatus is bonded to the middle frame.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A heat dissipation apparatus, configured to dissipate heat for an internal structure, wherein the heat dissipation apparatus comprises an adhesive region and a partial adhesive-free region, the adhesive region is bonded to the internal structure and covers a region of a heat emitting component, and the partial adhesive-free region is disposed in at least one corner of the heat dissipation apparatus.

2. The heat dissipation apparatus according to claim 1, wherein the partial adhesive-free region disposed in the corner of the heat dissipation apparatus falls within a rectangular region whose area is 15 mm×15 mm.

3. The heat dissipation apparatus according to claim 1 or 2, wherein the heat dissipation apparatus further comprises a first polymer film layer, a heat dissipation material layer, a second polymer film layer, and an adhesive layer that are sequentially stacked, and the adhesive layer is disposed in the adhesive region of the heat dissipation apparatus.

4. The heat dissipation apparatus according to claim 1 or 2, wherein the heat dissipation apparatus further comprises a third polymer film layer, a heat dissipation material layer, an adhesive layer, and a fourth polymer film layer that are sequentially stacked, the adhesive layer is disposed on an entire surface of the heat dissipation apparatus, and the fourth polymer film layer corresponds to the partial adhesive-free region of the heat dissipation apparatus.

5. The heat dissipation apparatus according to claim 1 or 2, wherein the heat dissipation apparatus further comprises a fifth polymer film layer, a heat dissipation material layer, and an adhesive layer that are sequentially stacked, and the adhesive layer is disposed in the adhesive region of the heat dissipation apparatus.

6. The heat dissipation apparatus according to any one of claims 3 to 5, wherein the heat dissipation material layer is a graphite layer or a graphene layer.

7. The heat dissipation apparatus according to any one of claims 1 to 6, wherein a shape of the partial adhesive-free region disposed in the corner of the heat dissipation apparatus is a triangle, a rectangle, a sector, or a trapezoid.

8. A terminal device, comprising a display, a middle frame, a rear housing, a printed circuit board, and the heat dissipation apparatus according to any one of claims 1 to 7, wherein
the middle frame is configured to bear the printed circuit board and the display, the display and the printed circuit board are located on two sides of the middle frame, and the rear housing is located on a side of the printed circuit board that is away from the display; and
heat emitting components are disposed on the printed circuit board, and the heat dissipation apparatus covers a region of the heat emitting component.

9. The terminal device according to claim 8, wherein the terminal device further comprises a bracket fastened to the middle frame, and the bracket is configured to press the printed circuit board against the middle frame.

10. The terminal device according to claim 9, wherein the heat dissipation apparatus is disposed on a side of the printed circuit board that is close to the rear housing, and is bonded to the bracket.
